(19)

Europäisches Patentamt
European Patent Office
Office européen des brevets

(11) **EP 4 224 725 A1**

(12) **EUROPEAN PATENT APPLICATION**
published in accordance with Art. 153(4) EPC

(43) Date of publication:
**09.08.2023 Bulletin 2023/32**

(21) Application number: **21874975.2**

(22) Date of filing: **23.08.2021**

(51) International Patent Classification (IPC):
**H04B 5/02** *(2006.01)*      **G06K 19/07** *(2006.01)*
**H04B 1/59** *(2006.01)*

(52) Cooperative Patent Classification (CPC):
**G06K 19/07; H04B 1/59; H04B 5/02**

(86) International application number:
**PCT/JP2021/030801**

(87) International publication number:
**WO 2022/070672 (07.04.2022 Gazette 2022/14)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **30.09.2020 JP 2020164908**

(71) Applicants:
• **Tokyo Institute of Technology**
  **Tokyo 152-8550 (JP)**
• **Kyocera Corporation**
  **Kyoto-shi Kyoto 612-8501 (JP)**

(72) Inventors:
• **ISHIHARA, Noboru**
  **Tokyo 152-8550 (JP)**
• **TSURU, Shinsuke**
  **Kyoto-shi, Kyoto 612-8501 (JP)**
• **YUZAWA, Tomonao**
  **Kyoto-shi, Kyoto 612-8501 (JP)**
• **ISOYAMA, Shinji**
  **Kyoto-shi, Kyoto 612-8501 (JP)**

(74) Representative: **Viering, Jentschura & Partner mbB**
**Patent- und Rechtsanwälte**
**Am Brauhaus 8**
**01099 Dresden (DE)**

(54) **TRANSFER CIRCUIT**

(57) A transmission circuit includes a first impedance circuit (110-1), a second impedance circuit (110-2), and a phase shifter (120). Each of the first impedance circuit (110-1) and the second impedance circuit (110-2) includes a register circuitry (112) and a control circuitry (111) that controls a resistance value of the register circuitry (112). The first impedance circuit (110-1) is configured to output a reflected wave of an input signal to the phase shifter. The phase shifter (120) is configured to shift a phase of the input signal to input the input signal to the first impedance circuit (110-1) and to shift a phase of the reflected wave of the input signal output from the first impedance circuit (110-1) to output the reflected wave to the combiner circuit (130). The second impedance circuit (110-2) is configured to output the reflected wave of the input signal to the combiner circuit (130).

FIG. 4

EP 4 224 725 A1

## Description

TECHNICAL FIELD

The present disclosure relates to a transmission circuit.

BACKGROUND OF INVENTION

A backscatter system is known as a data communication method of a wireless communication apparatus. For example, Patent Document 1 discloses a technique for implementing a single side band by suppressing either an upper side band (USB) signal or a lower side band (LSB) signal by using a demultiplexer/multiplexer.

CITATION LIST

PATENT LITERATURE

Patent Document 1: JP 2005-323223 A

SUMMARY

PROBLEM TO BE SOLVED

In a radio frequency identification (RFID) system that performs data communication of a backscatter system, miniaturization of a wireless communication apparatus is required. However, in Patent Document 1, a demultiplexer/multiplexer is used to implement a single side band, and thus a configuration is disadvantageous for miniaturization.

The present disclosure is directed to providing a transmission circuit capable of miniaturizing a wireless communication apparatus of a backscatter system.

SOLUTION TO PROBLEM

In an aspect of the present disclosure, a transmission circuit is configured to connect to an antenna. The transmission circuit includes a first impedance circuit, a second impedance circuit, and a phase shifter. Each of the first impedance circuit and the second impedance circuit includes a register circuitry and a control circuitry. The register circuitry includes a plurality of resistive elements and a plurality of switch elements. Each of the plurality of switch elements is connected to a respective one of the plurality of resistive elements. The control circuitry is configured to control a resistance value of the register circuit by controlling the plurality of switch elements. The first impedance circuit is configured to output a reflected wave of an input signal from an antenna to the phase shifter. The phase shifter is configured to shift a phase of the input signal from the antenna to input the input signal to the first impedance circuit, and to shift a phase of the reflected wave of the input signal from the antenna output from the first impedance circuit to output the reflected wave to a combiner circuit. The second impedance circuit is configured to output the reflected wave of the input signal from the antenna to the combiner circuit.

ADVANTAGEOUS EFFECT

According to the present disclosure, a wireless communication apparatus of a backscatter system can be miniaturized.

BRIEF DESCRIPTION OF THE DRAWINGS

FIG. 1 is a block diagram illustrating an example of a configuration of a wireless communication apparatus according to an embodiment.
FIG. 2 is a diagram for describing a method of rotationally controlling impedance in a complex plane according to the embodiment.
FIG. 3A is a diagram for describing a change in a backscattering signal.
FIG. 3B is a diagram for describing a change in a backscattering signal.
FIG. 3C is a diagram for describing a change in a backscattering signal.
FIG. 4 is a diagram for describing a method of controlling impedance of a transmission circuit according to the embodiment.
FIG. 5A is a diagram for describing an example of a signal input from an impedance circuit to a combiner circuit according to the embodiment.
FIG. 5B is a diagram for describing an example of a signal input from the impedance circuit to the combiner circuit according to the embodiment.
FIG. 6 is a diagram illustrating an example of a dipole antenna used as the combiner circuit according to the embodiment.
FIG. 7 is a diagram illustrating an example of a spectrum waveform of a combined signal according to the embodiment.
FIG. 8 is a diagram illustrating an example of a monopole antenna used as the combiner circuit according to the embodiment.
FIG. 9 is a diagram illustrating an example of a spectrum waveform of the combined signal according to the embodiment.

DESCRIPTION OF EMBODIMENTS

Embodiments according to the present disclosure will now be described in detail with reference to the accompanying drawings. Note that the present disclosure is not limited by the embodiments, and when there is a plurality of embodiments, the scope of the present disclosure includes a combination of the embodiments. In the following embodiments, the same reference numerals are assigned to the same portions and redundant descriptions thereof will be omitted.

Embodiment

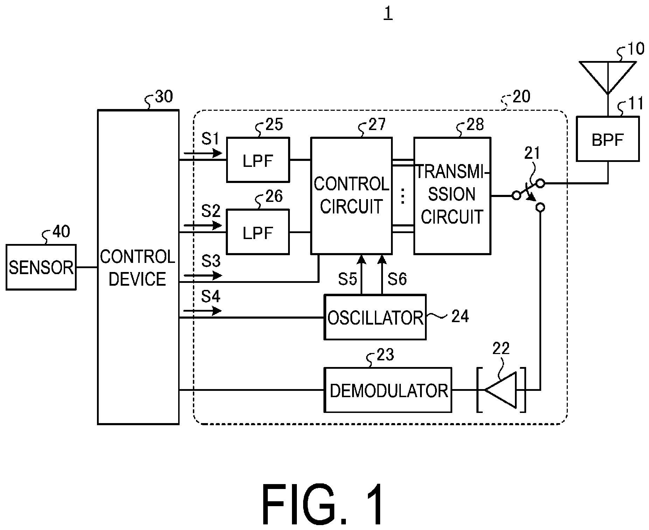

A configuration of a wireless communication apparatus according to an embodiment will be described with reference to FIG. 1. FIG. 1 is a block diagram illustrating an example of a configuration of the wireless communication apparatus according to an embodiment.

As illustrated in FIG. 1, a wireless communication apparatus 1 includes an antenna 10, a band ass filter (BPF) 11, a radio frequency backscatter (RFBS) device 20, a control device 30, and a sensor 40. The wireless communication apparatus 1 is a communication apparatus configured to perform wireless communication of a backscatter system such as an RFID.

The antenna 10 is configured to receive a signal transmitted to the wireless communication apparatus 1. The antenna 10 is configured to transmit a radio wave towards the outside of the wireless communication apparatus 1. The BPF 11 is a filter configured to pass a signal in a desired frequency band.

The RFBS device 20 includes a high frequency switch 21, an amplifier 22, a demodulator 23, an oscillator 24, a low pass filter (LPF) 25, an LPF 26, a control circuit 27, and a transmission circuit 28. The RFBS device 20 is a wireless communication device that supports data communication of the backscatter system. In the data communication of the backscatter system, communication is performed using reflection of the transmitted radio wave.

The high frequency switch 21 is configured to switch connection between the antenna 10 and a transmission circuit system or a reception circuit system. The high frequency switch 21 is configured to be able to connect the transmission circuit system to the antenna 10. The wireless communication apparatus 1 is configured to transmit when the antenna 10 and the transmission circuit system are connected. The high frequency switch 21 is configured to be able to connect the reception circuit system to the antenna 10. The transmission circuit system includes the oscillator 24, the LPF 25, the LPF 26, the control circuit 27, and the transmission circuit 28. The reception circuit system includes the amplifier 22, the demodulator 23.

The amplifier 22 is configured to amplify the signal received from the antenna 10 and output the amplified signal. The amplifier 22 is configured to output the amplified signal to the demodulator 23. The demodulator 23 is configured to execute demodulation processing on an input signal. The demodulator 23 is configured to demodulate a signal received from the amplifier 22. For example, the demodulator 23 is configured to execute demodulation processing on the signal (modulation signal such as amplitude shift keying (ASK)) received from the amplifier 22.

The control device 30 is implemented by, for example, a program stored inside executed by a processor or the like with a random access memory (RAM) or the like as a work area. The control device 30 may be a controller. The control device 30 may also be implemented by an integrated circuit such as an application specific integrated circuit (ASIC) or a field programmable gate array (FPGA). The control device 30 may also be implemented by a combination of software and hardware.

The control device 30 is configured to output serial data S1 based on output data from the sensor 40 to the control circuit 27 via the LPF 25. The control device 30 is configured to output serial data S2 based on the output data from the sensor 40 to the control circuit 27 via the LPF 26. The serial data S1 and S2 are different from each other in phases by approximately 90°.

The control device 30 is configured to output a control signal S3 for suppressing either the USB signal or the LSB signal with respect to a carrier signal to the control circuit 27. The control device 30 is configured to output a control signal S4 for controlling a channel used for communication to the oscillator 24.

The sensor 40 is configured to detect various physical quantities. The physical quantities detected by the sensor 40 are not particularly limited. The sensor 40 may include, for example, one or both of a temperature sensor configured to detect a temperature around the wireless communication apparatus 1, and an acceleration sensor configured to detect acceleration that is generated in the wireless communication apparatus 1. The sensor 40 may include other sensors.

The oscillator 24 is configured to generate an oscillation signal of a predetermined frequency. The oscillator 24 is configured to generate an oscillation signal S5 according to the control signal S4. The oscillator 24 is configured to generate an oscillation signal S6 having a phase different from the oscillation signal S5 by 90°.

The control circuit 27 is configured to control the transmission circuit 28. The control circuit 27 is configured to control a value of an impedance of the transmission circuit 28 based on the serial data S1, the serial data S2, and the control signal S3. The control circuit 27 is configured to change the impedance of the transmission circuit 28. Due to the change in the impedance, a reflection coefficient of an output terminal on the antenna 10 side rotates in a complex plane. The control circuit 27 changes the impedance of the transmission circuit 28 to control the reflection coefficient of the output terminal to rotate in the complex plane. For example, the control circuit 27 is configured to control the impedance of the transmission circuit 28 so as to reduce the USB signal or the LSB signal with respect to the carrier signal in a reflection signal (hereinafter, also referred to as the backscatter signal) to implement the single side band.

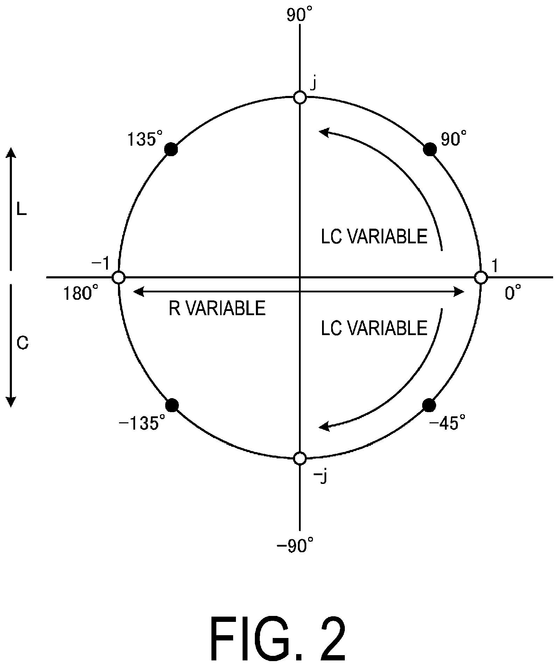

A method will be described, with reference to a polar chart (polar coordinate) in FIG. 2, in which the control circuit 27 controls the reflection coefficient of the output terminal on the antenna 10 side of the transmission circuit 28 so as to rotate on the complex plane of the polar chart. FIG. 2 is a diagram for describing a method in which the control circuit 27 changes the impedance of the transmission circuit 28 to control the reflection coefficient of the output terminal to rotate.

FIG. 2 is a diagram illustrating a change in a reflection coefficient Γ due to the change in the impedance on the polar chart. The impedance is calculated by the following equation (1). In the equation (1), z is impedance, R is resistance, j is an imaginary number, ω is an angular frequency, L is inductance, and C is capacitance.

$$Z = R + j(\omega L - 1/\omega C) \dots (1)$$

The reflection coefficient Γ is represented by the following equation.

$$\Gamma = (Z - Z_0)/(Z + Z_0) \dots (2)$$

Here $Z_0$ is an impedance of the antenna 10 or the BPF 11.

The control circuit 27 selectively controls the impedance Z to control the reflection coefficient Γ so as to rotate around a reference point. The reference point includes the origin, but is not limited to the origin and includes any point. The closer to the origin the reference point is, the closer signal to the ideal one the transmission circuit can obtain. The more a periphery of the reference point is controlled to circularly rotate, the closer signal to the ideal one the transmission circuit can obtain. In consideration in a Smith chart, a lower semicircular region indicates a capacitive property, and an upper half indicates an inductive property. A change on the real axis represents a change in a resistance value.

The control circuit 27 can selectively control a plurality of impedances included in the transmission circuit 28. For example, the control circuit 27 is configured to control the impedance of the transmission circuit 28 in 45° increments, namely 0°, 45°, 90°, 135°, 180°,-135°, -90°, -45°. The control circuit 27 is configured to control a voltage reflection coefficient Γ by controlling the impedance. The control circuit 27 is configured to be controllable to discretely rotate the impedance by sequentially changing the impedance of the transmission circuit 28. The control circuit 27 discretely rotates the reflection coefficient Γ in response to discrete rotation of the impedance.

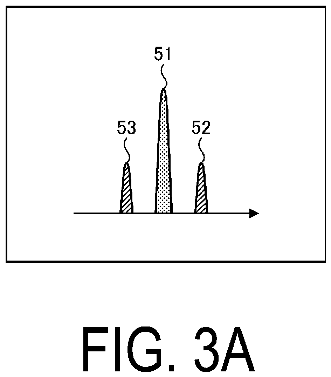

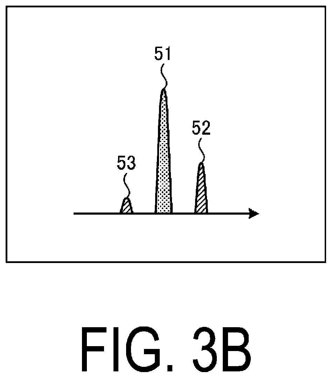

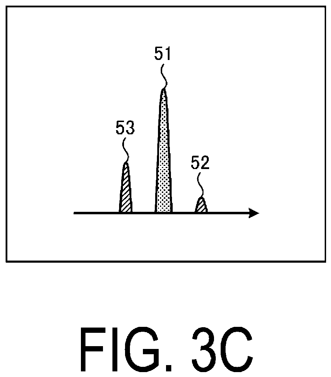

The control circuit 27 is configured to be able to change the impedance in counterclockwise rotation by a changing order of the impedance of the transmission circuit 28. The control circuit 27 is configured to be able to change the reflection coefficient Γ in the counterclockwise rotation by the counterclockwise rotation of the impedance. When the control of the reflection coefficient is counterclockwise rotation, the reflection signal with respect to the radio frequency (RF) is only the upper side band (USB) signal. When the reflection coefficient is controlled to be clockwise rotation, only the lower side band (LSB) signal is obtained. At that time, the frequency of the reflection signal is detuned from the RF signal frequency by a rotation speed frequency. Several examples of change in the backscatter signal due to change of the impedance to control the reflection coefficient will be described with reference to FIG. 3A, 3B, and 3C.

FIG. 3A is a diagram illustrating a frequency spectrum for describing a state of the backscatter signal when the control circuit 27 controls only a resistive component of the impedance, and changes the reflection coefficient Γ on the real axis of the polar chart (FIG. 2). The horizontal axis represents the frequency, and the vertical axis represents the intensity of the RF signal and the reflection signal. In FIG. 3A, a carrier signal 51, a USB signal 52, and an LSB signal 53 are illustrated. When the resistive component is controlled, the reflection coefficient Γ is controlled to either 0° or 180° on the real axis. When the impedance is changed by only the resistive component to control the reflection coefficient Γ, as illustrated in FIG. 3A, the clockwise signal component and the counterclockwise signal component are present in switching from 0° to 180°, for example. The signal components in the two rotational directions are present, and thus the USB signal 52 and the LSB signal 53 appear simultaneously, and only one of the signals cannot be selectively suppressed. As a result, an SSB signal cannot be obtained by controlling only the resistive component.

FIG. 3B is a diagram illustrating a frequency spectrum for describing a change in the backscatter signal when the control circuit 27 changes inductance/capacitance of the impedance to control a trajectory of the reflection coefficient Γ so as to form a circle. The horizontal axis represents the frequency, and the vertical axis represents the intensity of the RF signal and the reflection signal. Based on the equations (1) and (2), the control circuit 27 is controllable to rotate the impedance counterclockwise by controlling a value of the inductance. At this time, the impedance is rotated counterclockwise, for example, from 0° to 45°, 90°, and 135°. The control circuit 27 is controllable to rotate the impedance counterclockwise by further controlling a value of the capacitance. At this time, the impedance is rotated counterclockwise, for example, from 180° to -135°, -90°, and -45°. As illustrated in FIG. 3B, the control circuit 27 can reflect the transmitted RF signal so as to suppress the LSB signal 53 by controlling the impedance to rotate counterclockwise. In other words, the control circuit 27 can obtain a backscatter signal that is SSB modified to the USB signal 52 by counterclockwise rotation control of the impedance.

FIG. 3C is a diagram for describing a change in the backscatter signal when the control circuit 27 changes capacitance/inductance of the impedance to control a trajectory of the reflection coefficient Γ to form a circle. Based on the equations (1) and (2), the control circuit 27 is controllable to rotate the impedance clockwise by controlling the value of the capacitance. At this time, the impedance is rotated clockwise, for example, from 0° to

-45°, - 90°, and -135°. The control circuit 27 is controllable to rotate the impedance clockwise by further controlling the value of the inductance. At this time, the impedance is rotated clockwise, for example, from 180°, to 135°, 90°, and 45°. As illustrated in FIG. 3C, the control circuit 27 can reflect the transmitted RF signal so as to suppress the USB signal 52 by controlling the impedance to rotate clockwise. In other words, the control circuit 27 can obtain a backscatter signal that is SSB modified to the LSB signal 53 by clockwise rotation control of the impedance.

The transmission circuit 28 is disposed on a front end of the wireless communication apparatus 1. The transmission circuit 28 is a circuit configured to perform backscatter communication in which the transmitted radio wave is reflected as the backscatter signal. The transmission circuit 28 is configured to be connected to the antenna 10. The transmission circuit 28 includes a plurality of impedance circuits having impedances different from each other. Each of the plurality of impedance circuits includes a switch element. The switch element is configured to switch a connection of a corresponding impedance circuit. The control circuit 27 is configured to control the connection of the plurality of impedance circuits by controlling a plurality of switch elements. The control circuit 27 is configured to control the impedance of the transmission circuit 28 by controlling the plurality of switch elements.

Method of Controlling Impedance

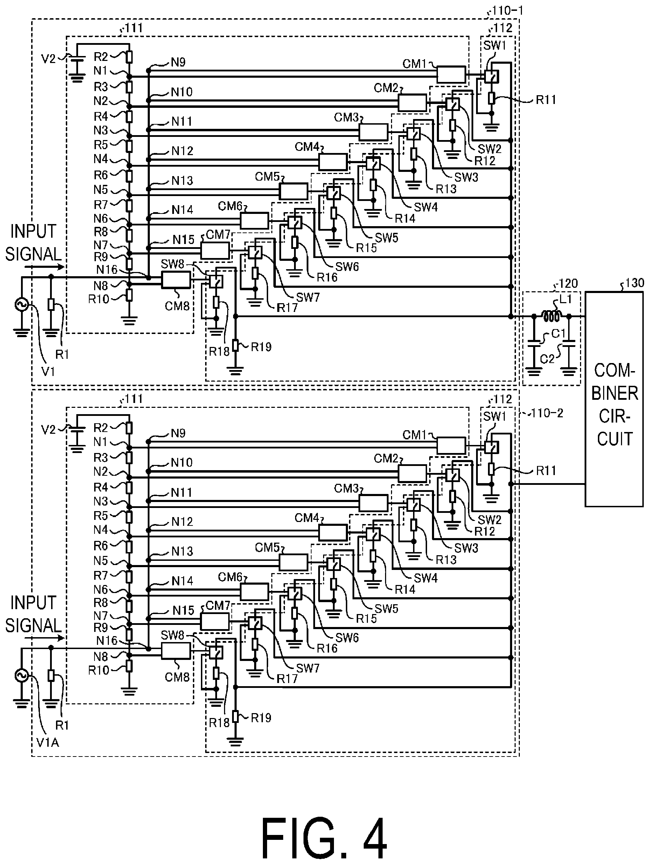

A method of controlling the impedance according to the embodiment will be described with reference to FIG. 4. FIG. 4 is a diagram for describing a method of controlling the impedance according to the embodiment.

FIG. 4 illustrates an impedance circuit 110-1, an impedance circuit 110-2, control circuitries 111, switch circuitries 112, and a phase shifter 120. The impedance circuit 110-1 is connected to a combiner circuit 130 on the antenna 10 side via the phase shifter 120. The impedance circuit 110-2 is directly connected to the combiner circuit 130. The impedance circuit 110-1 and the impedance circuit 110-2 have the same and/or similar configurations. The impedance circuit 110-1 may also be referred to as a first impedance circuit. The impedance circuit 110-2 may also be referred to as a second impedance circuit. When it is not necessary to distinguish between the impedance circuit 110-1 and the impedance circuit 110-2, these may be collectively referred to as an impedance circuit 110.

The transmission circuit 28 illustrated in FIG. 1 includes the switch circuitry 112 and the phase shifter 120. The control circuit 27 illustrated in FIG. 1 includes the control circuitry 111. The control circuitry 111 is located at an output unit of the control circuit 27. The control circuitry 111 is configured to control opening and closing of each switch element included in the switch circuitry 112.

The impedance circuit 110 includes a resistive element R1, the control circuitry 111, and the switch circuitry 112. The control circuitry 111 controls a resistance value of the switch circuitry 112. The switch circuitry 112 includes a plurality of resistive elements. The switch circuitry 112 is also referred to as a register circuitry.

A signal source V1 and a signal source V1A indicate signal sources of the control signals input via the LPF 25 and the LPF 26, respectively, illustrated in FIG. 1 from the control device 30 in accordance with a detection result from the sensor 40 and the like. The resistive element R1 is connected to the signal source V1. The resistive element R1 is a ground resistance that sets an input resistance. Higher resistance is typically used for the ground resistance.

The control circuitry 111 includes a reference power supply V2, a resistive element R2, a resistive element R3, a resistive element R4, a resistive element R5, a resistive element R6, a resistive element R7, a resistive element R8, a resistive element R9, and a resistive element R10. The control circuitry 111 includes a comparator CM1, a comparator CM2, a comparator CM3, a comparator CM4, a comparator CM5, a comparator CM6, a comparator CM7, and a comparator CM8.

The resistive element R2 to the resistive element R10 are connected to each other in series. The resistive element R2 to the resistive element R10 constitute a voltage dividing circuit.

A node N1 is a node between the resistive element R2 and the resistive element R3. A node N2 is a node between the resistive element R3 and the resistive element R4. A node N3 is a node between the resistive element R4 and the resistive element R5. A node N4 is a node between the resistive element R5 and the resistive element R6. A node N5 is a node between the resistive element R6 and the resistive element R7. A node N6 is a node between the resistive element R7 and the resistive element R8. A node N7 is a node between the resistive element R8 and the resistive element R9. A node N9 is a node between the resistive element R9 and the resistive element R10. A voltage value of a reference voltage of the reference power supply V2 and a divided voltage and an input signal level corresponding to a resistance value of each of the resistive element R2 to the resistive element R10 are compared by the comparator CM1 to the comparator CM8, and an output of each comparator is output from a respective one of the node N1 to the node N9 as a control signal of the switch circuitry 112.

Each of the node N9, node N10, node N11, node N12, node N13, node N14, node N15, and node N16 is a node to which an input signal input to the control circuitry 111 is input.

The switch circuitry 112 includes a switch element SW1, a switch element SW2, a switch element SW3, a switch element SW4, a switch element SW5, a switch element SW6, a switch element SW7, and a switch element SW8.

The node N9 is electrically connected to one input terminal of the comparator CM1. The node N1 is electrically connected to the other input terminal of the comparator CM1. An output terminal of the comparator CM1 is electrically connected to one input terminal of the switch element SW1. The comparator CM1 compares the input signal input from the node N9 and a first divided voltage as the control signal input from the node N1 to output a switch control signal in accordance with the comparison result to the switch element SW1. For example, when the first divided voltage is greater than the input signal, the comparator CM1 outputs a switch control signal that brings the switch element SW1 into a closed state. When the first divided voltage is smaller than the input signal, the comparator CM1 outputs the switch control signal that brings the switch element SW1 into an open state.

One input terminal of the switch element SW1 is electrically connected to the output terminal of the comparator CM1. The other input terminal of the switch element SW1 is electrically connected to a reference potential. One end of the switch element SW1 is connected to the combiner circuit 130 via the phase shifter 120. The other end of the switch element SW1 is electrically connected to GND (ground) via a resistive element R11. When the switch element SW1 is in the closed state, the resistive element R11 and the combiner circuit 130 are electrically connected to each other. When the switch element SW1 is in the open state, the resistive element R11 and the combiner circuit 130 are electrically separated. That is, when the switch element SW1 is in the open state, the resistance value of the resistive element R11 is added to the impedance of the impedance circuit 110.

The node N10 is electrically connected to one input terminal of the comparator CM2. The node N2 is electrically connected to the other input terminal of the comparator CM2. An output terminal of the comparator CM2 is electrically connected to one input terminal of the switch element SW2. The comparator CM2 compares the input signal input from the node N10 and a second divided voltage as the control signal input from the node N2 to output a switch control signal in accordance with the comparison result to the switch element SW2. For example, when the second divided voltage is greater than the input signal, the comparator CM2 outputs the switch control signal that brings the switch element SW2 into the closed state. When the second divided voltage is smaller than the input signal, the comparator CM2 outputs the switch control signal that brings the switch element SW2 into the open state.

One input terminal of the switch element SW2 is electrically connected to the output terminal of the comparator CM2. The other input terminal of the switch element SW2 is electrically connected to the reference potential. One end of the switch element SW2 is connected to the combiner circuit 130 via the phase shifter 120. The other end of the switch element SW2 is electrically connected to the GND via the resistive element R12. When the switch element SW2 is in the closed state, the resistive element R12 and the combiner circuit 130 are electrically connected to each other. When the switch element SW2 is in the open state, the resistive element R12 and the combiner circuit 130 are electrically separated. That is, when the switch element SW2 is in the open state, the resistance value of the resistive element R12 is added to the impedance of the impedance circuit 110.

The node N11 is electrically connected to one input terminal of the comparator CM3. The node N3 is electrically connected to the other input terminal of the comparator CM3. An output terminal of the comparator CM3 is electrically connected to one input terminal of the switch element SW3. The comparator CM3 compares the input signal input from the node N11 and a third divided voltage as the control signal input from the node N3 to output a switch control signal in accordance with the comparison result to the switch element SW3. For example, when the third divided voltage is greater than the input signal, the comparator CM3 outputs the switch control signal that brings the switch element SW3 into the closed state. When the third divided voltage is smaller than the input signal, the comparator CM3 outputs the switch control signal that brings the switch element SW3 into the open state.

One input terminal of the switch element SW3 is electrically connected to the output terminal of the comparator CM3. The other input terminal of the switch element SW3 is electrically connected to the reference potential. One end of the switch element SW3 is connected to the combiner circuit 130 via the phase shifter 120. The other end of the switch element SW3 is electrically connected to the GND via the resistive element R13. When the switch element SW3 is in the closed state, the resistive element R13 and the combiner circuit 130 are electrically connected to each other. When the switch element SW3 is in the open state, the resistive element R13 and the combiner circuit 130 are electrically separated. That is, when the switch element SW3 is in the open state, the resistance value of the resistive element R13 is added to the impedance of the impedance circuit 110.

The node N12 is electrically connected to one input terminal of the comparator CM4. The node N4 is electrically connected to the other input terminal of the comparator CM4. An output terminal of the comparator CM4 is electrically connected to one input terminal of the switch element SW4. The comparator CM4 compares the input signal input from the node N12 and a fourth divided voltage as the control signal input from the node N4 to output a switch control signal in accordance with the comparison result to the switch element SW4. For example, when the fourth divided voltage is greater than the input signal, the comparator CM4 outputs the switch control signal that brings the switch element SW4 into the closed state. When the fourth divided voltage is smaller than the input signal, the comparator CM4 outputs the switch control signal that brings the switch element SW4 into the open state.

One input terminal of the switch element SW4 is electrically connected to the output terminal of the comparator CM4. The other input terminal of the switch element SW4 is electrically connected to the reference potential. One end of the switch element SW4 is connected to the combiner circuit 130 via the phase shifter 120. The other end of the switch element SW4 is electrically connected to the GND via the resistive element R14. When the switch element SW4 is in the closed state, the resistive element R14 and the combiner circuit 130 are electrically connected to each other. When the switch element SW4 is in the open state, the resistive element R14 and the combiner circuit 130 are electrically separated. That is, when the switch element SW4 is in the open state, the resistance value of the resistive element R14 is added to the impedance of the impedance circuit 110.

The node N13 is electrically connected to one input terminal of the comparator CM5. The node N5 is electrically connected to the other input terminal of the comparator CM5. An output terminal of the comparator CM5 is electrically connected to one input terminal of the switch element SW5. The comparator CM5 compares the input signal input from the node N13 and a fifth divided voltage as the control signal input from the node N5 to output a switch control signal in accordance with the comparison result to the switch element SW5. For example, when the fifth divided voltage is greater than the input signal, the comparator CM5 outputs the switch control signal that brings the switch element SW5 into the closed state. When the fifth divided voltage is smaller than the input signal, the comparator CM5 outputs the switch control signal that brings the switch element SW5 into the open state.

One input terminal of the switch element SW5 is electrically connected to the output terminal of the comparator CM5. The other input terminal of the switch element SW5 is electrically connected to the reference potential. One end of the switch element SW5 is connected to the combiner circuit 130 via the phase shifter 120. The other end of the switch element SW5 is electrically connected to the GND via the resistive element R15. When the switch element SW5 is in the closed state, the resistive element R15 and the combiner circuit 130 are electrically connected to each other. When the switch element SW5 is in the open state, the resistive element R15 and the combiner circuit 130 are electrically separated. That is, when the switch element SW5 is in the open state, the resistance value of the resistive element R15 is added to the impedance of the impedance circuit 110.

The node N14 is electrically connected to one input terminal of the comparator CM6. The node N6 is electrically connected to the other input terminal of the comparator CM6. An output terminal of the comparator CM6 is electrically connected to one input terminal of the switch element SW6. The comparator CM6 compares the input signal input from the node N14 and a sixth divided voltage as the control signal input from the node N6 to output a switch control signal in accordance with the comparison result to the switch element SW6. For example, when the sixth divided voltage is greater than the input signal, the comparator CM6 outputs the switch control signal that brings the switch element SW6 into the closed state. When the sixth divided voltage is smaller than the input signal, the comparator CM6 outputs the switch control signal that brings the switch element SW6 into the open state.

One input terminal of the switch element SW6 is electrically connected to the output terminal of the comparator CM6. The other input terminal of the switch element SW6 is electrically connected to the reference potential. One end of the switch element SW6 is connected to the combiner circuit 130 via the phase shifter 120. The other end of the switch element SW6 is electrically connected to the GND via the resistive element R16. When the switch element SW6 is in the closed state, the resistive element R16 and the combiner circuit 130 are electrically connected to each other. When the switch element SW6 is in the open state, the resistive element R16 and the combiner circuit 130 are electrically separated. That is, when the switch element SW6 is in the open state, the resistance value of the resistive element R16 is added to the impedance of the impedance circuit 110.

The node N15 is electrically connected to one input terminal of the comparator CM7. The node N7 is electrically connected to the other input terminal of the comparator CM7. An output terminal of the comparator CM7 is electrically connected to one input terminal of the switch element SW7. The comparator CM7 compares the input signal input from the node N15 and a seventh divided voltage as the control signal input from the node N7 to output a switch control signal in accordance with the comparison result to the switch element SW7. For example, when the seventh divided voltage is greater than the input signal, the comparator CM7 outputs the switch control signal that brings the switch element SW7 into the closed state. When the seventh divided voltage is smaller than the input signal, the comparator CM7 outputs the switch control signal that brings the switch element SW7 into the open state.

One input terminal of the switch element SW7 is electrically connected to the output terminal of the comparator CM7. The other input terminal of the switch element SW7 is electrically connected to the reference potential. One end of the switch element SW7 is connected to the combiner circuit 130 via the phase shifter 120. The other end of the switch element SW7 is electrically connected to the GND via the resistive element R17. When the switch element SW7 is in the closed state, the resistive element R17 and the combiner circuit 130 are electrically connected to each other. When the switch element SW7 is in the open state, the resistive element R17 and the combiner circuit 130 are electrically separated. That is, when the switch element SW7 is in the open state, the resistance value of the resistive element R17 is added to the impedance of the impedance circuit 110.

The node N16 is electrically connected to one input terminal of the comparator CM8. The node N8 is electrically connected to the other input terminal of the comparator CM8. An output terminal of the comparator CM8 is electrically connected to one input terminal of the switch element SW8. The comparator CM8 compares the input signal input from the node N16 and an eighth divided voltage as the control signal input from the node N8 to output a switch control signal in accordance with the comparison result to the switch element SW8. For example, when the eighth divided voltage is greater than the input signal, the comparator CM8 outputs the switch control signal that brings the switch element SW8 into the closed state. When the eighth divided voltage is smaller than the input signal, the comparator CM8 outputs the switch control signal that brings the switch element SW8 into the open state.

One input terminal of the switch element SW8 is electrically connected to the output terminal of the comparator CM8. The other input terminal of the switch element SW8 is electrically connected to the reference potential. One end of the switch element SW8 is connected to the combiner circuit 130 via the phase shifter 120. The other end of the switch element SW8 is electrically connected to the resistive element R18. When the switch element SW8 is in the closed state, the resistive element R18 and the combiner circuit 130 are electrically connected to each other. When the switch element SW8 is in the open state, the resistive element R18 and the combiner circuit 130 are electrically separated. That is, when the switch element SW8 is in the open state, the resistance value of the resistive element R18 is added to the impedance of the impedance circuit 110.

The impedance circuit 110 outputs a signal corresponding to open and closed states of the switch element SW1 to the switch element SW8. The impedance circuit 110-1 outputs a signal corresponding to the open and closed states of the switch element SW1 to the switch element SW8 to the phase shifter 120. The impedance circuit 110-2 outputs a signal corresponding to the open and closed states of the switch element SW1 to the switch element SW8 to the combiner circuit 130. The magnitudes of the signals output from the impedance circuit 110-1 and the impedance circuit 110-2 are the same.

The operation of the impedance circuit 110 will be described. As the voltage value of the input signal gradually increases, the control signals output in order of the comparator CM8, the comparator CM7, the comparator CM6, the comparator CM5, the comparator CM4, the comparator CM3, the comparator CM2, and the comparator CM1 are switched from Low to High. These control signals turn on the switch element SW8, the switch element SW7, the switch element SW6, the switch element SW5, the switch element SW4, the switch element SW3, the switch element SW2, and the switch element SW1 in this order. When the switch elements are turned on, the resistive element connected to each of the switch elements is electrically connected to the impedance circuit 110. That is, the resistive element R18, the resistive element R17, the resistive element R16, the resistive element R15, the resistive element R14, the resistive element R13, the resistive element R12, and the resistive element R11 are electrically connected to the impedance circuit 110 in parallel in this order. Thus, the resistance value of each of the resistive element R18 to the resistive element R11 is added in parallel to the resistance value of the switch circuitry 112 as viewed from the output side. Note that the resistive element R19 is a high resistive element that hinders the potential from being floating when the switch element SW1 to the switch element SW8 are turned off.

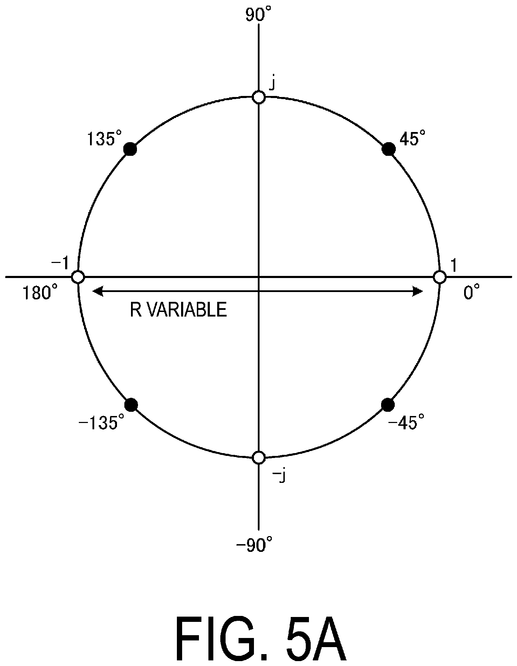

In the impedance circuit 110-1, the resistance value of each resistive element is set so that the resistance value of each resistive element connected to the respective one of the switch elements is added in parallel and thus the reflection coefficient represented by the complex plane changes on the real number axis. FIG. 5A is a diagram for describing how the reflection coefficient changes on the real number axis. As illustrated in FIG. 5A, the impedance circuit 110-1 is configured such that the reflection coefficient is changed from 1 to -1 on the real axis by turning on the switch element SW1 to the switch element SW8 in order.

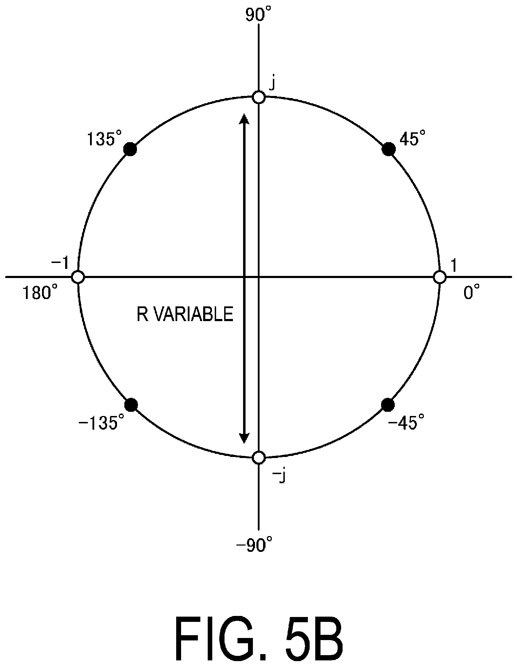

When a phase of the input signal is delayed by 90°, the resistance value changes with being delayed by 90°, and thus change in impedance on the imaginary number axis can be equivalently expressed. That is, the impedance circuit 110-2 is configured to allow the reflection coefficient to change on the imaginary number axis. FIG. 5B is a diagram for describing how the reflection coefficient changes on the real number axis. As illustrated in FIG. 5B, the impedance circuit 110-2 is configured such that the reflection coefficient is changed from j to j on the imaginary number axis by turning on the switch element SW1 to the switch element SW8 in order.

The phase shifter 120 is disposed between the impedance circuit 110-1 and the combiner circuit 130. The phase shifter 120 includes an inductor L1, a capacitor C1, and a capacitor C2. One end of the inductor L1 is electrically connected to the capacitor C1. The other end of the inductor L1 is electrically connected to the capacitor C2. The capacitor C1 and the capacitor C2 are grounded. A delay amount of the phase shifter is set to be 45° for a high-frequency signal.

One end of the phase shifter 120 is electrically connected to the impedance circuit 110-1. The other end of the phase shifter 120 is electrically connected to the combiner circuit 130. That is, the phase shifter 120 shifts the phase of the input signal from the combiner circuit 130 to input the input signal to the impedance circuit 110-1. The phase shifter 120 shifts a phase of a reflected wave from the impedance circuit 110-1 to input the reflected wave to the combiner circuit 130. The phase shifter 120 is, for example, a phase shifter that delays the phase by 45° to output the phase. In this case, the phases of the reflected waves input to the combiner circuit from the impedance circuit 110-1 and the impedance circuit 110-2 are different from each other by 90°.

The combiner circuit 130 combines a signal input from the outside. The combiner circuit 130 combines signals input from the impedance circuit 110-1 and the impedance circuit 110-2. That is, the combiner circuit 130 can obtain a signal whose reflection coefficient is rotationally controlled by impedance control on the circle of the complex plane (polar coordinate) illustrated in FIGs. 5A and 5B and the like by combining a signal whose impedance is controlled on the real axis and the phase is delayed by 45° and a signal whose impedance is controlled on the imaginary axis. The combiner circuit 300 is not particularly limited. The combiner circuit 300 can be implemented by, for example, an existing dipole antenna and a monopole antenna.

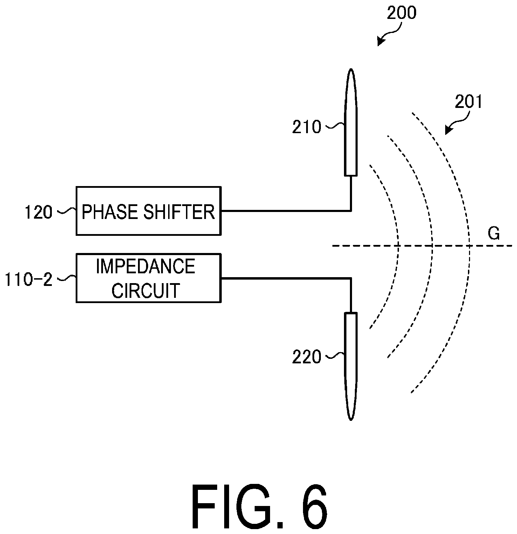

The dipole antenna used as the combiner circuit will be described with reference to FIG. 6. FIG. 6 is a diagram illustrating an example of the dipole antenna used as the combiner circuit.

As illustrated in FIG. 6, a dipole antenna 200 includes a conducting wire 210 and a conducting wire 220. The conducting wire 210 is a conducting wire connected to the phase shifter 120. The conducting wire 220 is a conducting wire connected to the impedance circuit 110-2. The dipole antenna 200 is configured to be independent of a ground G.

A backscatter signal obtained by delaying, by the phase shifter 120, the phase of the backscatter signal, whose impedance is controlled on the real axis, by 45° in the complex plane is input in the conducting wire 210. A backscatter signal whose impedance is controlled on the imaginary axis in the complex plane is input in the conducting wire 220. That is, two backscatter signals having phases different from each other are input to the dipole antenna 200.

The dipole antenna 200 spatially combines the two backscatter signals having phases different from each other. A combined signal of the combined backscatter signal can be expressed as "combined signal = $\cos\theta + j\sin\theta$" where $\theta$ is an angle of the phase, and j is an imaginary number. That is, the dipole antenna 200 can control the impedance to rotate by combining the two backscatter signals. The dipole antenna 200 spatially combines the two backscatter signals having phases different from each other to transmit a radio wave 201.

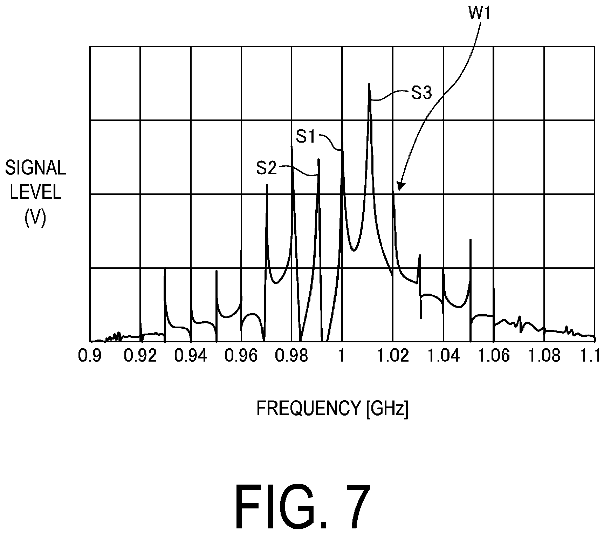

A spectrum waveform of the combined signal of the two backscatter signals will be described with reference to FIG. 7. FIG. 7 is a diagram illustrating an example of a spectrum waveform of the combined signal according to the embodiment.

FIG. 7 illustrates a spectrum waveform W1 of the combined signal of the two backscatter signals combined by the dipole antenna 200. The spectrum waveform W1 includes a carrier signal S1, an LSB signal S2, and a USB signal S3. The frequency of the carrier signal S1 is 1.0 GHz. The frequency of the LSB signal S2 is 0.99 GHz. The frequency of the USB signal S3 is 1.01 GHz. As illustrated in FIG. 7, in the spectrum waveform W1, the LSB signal S2 is suppressed as compared with the LSB signal S3. That is, in the spectrum waveform W1, a single band of the USB signal S3 is implemented.

In FIG. 7, the example is described in which the two backscatter signals are combined using the dipole antenna 200, but the present disclosure is not limited thereto. For example, in the present disclosure, the two backscatter signals may be combined using the monopole antenna.

The combiner circuit according to the present embodiment is not limited to the dipole antenna. The combiner circuit according to the present embodiment may be the monopole antenna.

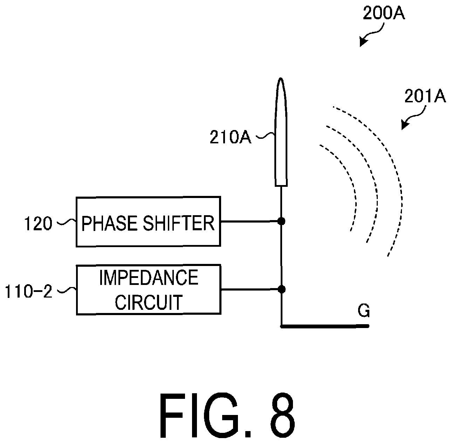

The monopole antenna used as the combiner circuit will be described with reference to FIG. 8. FIG. 8 is a diagram illustrating an example of the monopole antenna according to the embodiment.

The monopole antenna 200A includes a conducting wire 210A. The conducting wire 210A is a conducting wire connected to the impedance circuit 110-2 and the phase shifter 120. The monopole antenna 200A is electrically connected to the ground G.

A backscatter signal obtained by delaying, by the phase shifter 120, the phase of the backscatter signal, whose impedance is controlled on the real axis, by 45° in the complex plane and a backscatter signal whose impedance is controlled on the imaginary axis are input in the conducting wire 210A. That is, two backscatter signals having phases different from each other are input to the monopole antenna 200A.

The monopole antenna 200A spatially combines the two backscatter signals having phases different from each other. A combined signal of the combined backscatter signal can be expressed as "combined signal = $\cos\theta + j\sin\theta$" where $\theta$ is an angle of the phase, and j is an imaginary number. That is, the monopole antenna 200A can control the impedance to rotate by combining the two backscatter signals. The monopole antenna 200A spatially combines the two backscatter signals having phases different from each other to transmit a radio wave 201A.

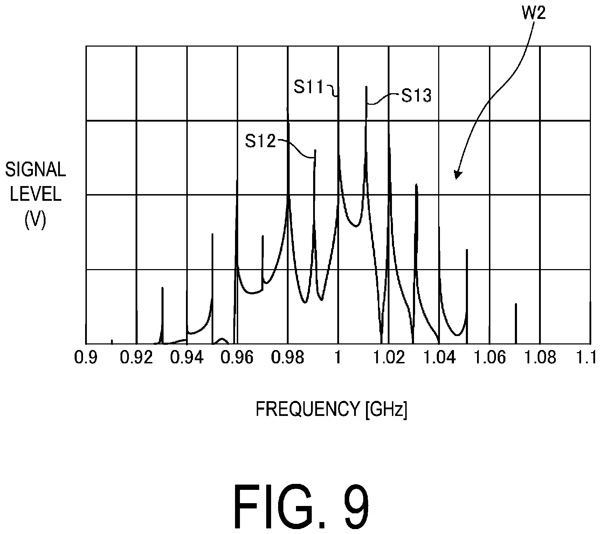

A spectrum waveform of the combined signal of the two backscatter signals will be described with reference to FIG. 9. FIG. 9 is a diagram illustrating an example of a spectrum waveform of the combined signal according to the embodiment.

FIG. 9 illustrates a spectrum waveform W2 of the combined signal of the two backscatter signals combined by the monopole antenna 200A. The spectrum waveform W2 includes a carrier signal S11, an LSB signal S12, and a USB signal S13. The frequency of the carrier signal S11 is 1.0 GHz. The frequency of the LSB signal S12 is 0.99 GHz. The frequency of the USB signal S13 is 1.01 GHz. As illustrated in FIG. 9, in the spectrum waveform W2, the LSB signal S12 is suppressed. That is, in the spectrum waveform W2, a single band of the USB signal S13 is implemented. As compared with FIG. 7, peaks appear in a band adjacent to the LSB signal S12 and a band adjacent to the USB signal S13, but the single band of the USB signal S13 is implemented.

As illustrated in FIG. 7 and FIG. 9, the peaks appear in the USB signal S3 and the USB signal S13 on the upper side of the SSB signal. Here, when a relationship between the phases of the input signals output from the signal source V1 and the signal source V1A is reversed, peaks appear in the LSB signal S2 and the LSB signal S12. That is, the transmission circuit 28 is configured to be able to appropriately adjust positions at which the peaks appear by adjusting the phases of the input signals input to the impedance circuit 110-1 and the impedance circuit 110-2.

As described above, in the present embodiment, the transmission circuit includes the two impedance circuits including only the resistive elements. In the present embodiment, the backscatter signal of one impedance circuit is directly input to the combiner circuit, and the backscatter signal of the other impedance circuit is input to the combiner circuit with the phase being inverted by 90°. The present embodiment can implement the single side band of the backscatter signal by combining the two backscatter signals.

In the present embodiment, the impedance circuits of the transmission circuit do not include an inductor nor a capacitor, but includes only the resistive elements. In this way, in the present embodiment, the transmission circuit is easily formed to be an IC. As a result, the present embodiment has an advantageous configuration for miniaturization.

The embodiments of the present disclosure have been described above, but the present disclosure is not limited by the contents of these embodiments. The components described above include elements that can be easily conceived by those skilled in the art, elements that are substantially the same, and elements in a so-called equivalent range. Furthermore, the components described above can be combined as appropriate. Furthermore, various omitted, substituted, or modified components can be made without departing from the spirit of the above-described embodiments.

REFERENCE SIGNS

1 Wireless communication apparatus
10 Antenna
11 BPF
20 RFBS device
21 High frequency switch
22 Amplifier
23 Demodulator
24 Oscillator
25, 26 LPF
27 Control circuit
28 Transmission circuit
110 Impedance circuit
111 Control circuitry

112 Switch circuitry
120 Phase shifter
130 Combiner circuit
200 Dipole antenna
200A Monopole antenna
SW1 to SW8 Switch element

**Claims**

1. A transmission circuit configured to connect to an antenna, the transmission circuit comprising:

   a first impedance circuit;
   a second impedance circuit; and
   a phase shifter, wherein
   each of the first impedance circuit and the second impedance circuit comprises

   a register circuitry comprising

   a plurality of resistive elements and
   a plurality of switch elements, each of the plurality of switch elements being connected to a respective one of the plurality of resistive elements, and

   a control circuitry configured to control a resistance value of the register circuitry by controlling the plurality of switch elements,

   wherein
   the first impedance circuit is configured to output a reflected wave of an input signal from an antenna to the phase shifter,
   the phase shifter is configured to shift a phase of the input signal from the antenna to input the input signal to the first impedance circuit, and to shift a phase of the reflected wave of the input signal from the antenna output from the first impedance circuit to output the reflected wave to a combiner circuit, and
   the second impedance circuit is configured to output the reflected wave of the input signal from the antenna to the combiner circuit.

2. The transmission circuit according to claim 1, wherein
   the control circuitry comprises a plurality of resistive elements configured to divide an input reference voltage and output divided electrical power configured to control open and closed states of each of the plurality of switch elements.

3. The transmission circuit according to claim 1 or 2, wherein
   the control circuitry is configured to control the resistance value of the register circuitry by setting at least one switch element of the plurality of switch elements to the closed state.

4. The transmission circuit according to any one of claims 1 to 3, wherein
the combiner circuit comprises an antenna.

5. The transmission circuit according to claim 4, wherein
the antenna comprises a dipole antenna.

FIG. 1

# FIG. 2

FIG. 3A

FIG. 3B

# FIG. 3C

FIG. 4

FIG. 5A

FIG. 5B

200

201

210

120 PHASE SHIFTER

110-2 IMPEDANCE CIRCUIT

G

220

# FIG. 6

FIG. 7

200A

201A

210A

120 — PHASE SHIFTER

110-2 — IMPEDANCE CIRCUIT

G

# FIG. 8

FIG. 9

## INTERNATIONAL SEARCH REPORT

| International application No. |
|---|
| **PCT/JP2021/030801** |

**A.     CLASSIFICATION OF SUBJECT MATTER**

*H04B 5/02*(2006.01)i; *G06K 19/07*(2006.01)i; *H04B 1/59*(2006.01)i
FI:    H04B5/02; G06K19/07 230; H04B1/59

According to International Patent Classification (IPC) or to both national classification and IPC

**B.     FIELDS SEARCHED**

Minimum documentation searched (classification system followed by classification symbols)

H04B5/02; G06K19/07; H04B1/59

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

**C.     DOCUMENTS CONSIDERED TO BE RELEVANT**

| Category* | Citation of document, with indication, where appropriate, of the relevant passages | Relevant to claim No. |
|---|---|---|
| A | JP 2009-232372 A (SONY CORP.) 08 October 2009 (2009-10-08) entire text, all drawings | 1-5 |
| A | US 2018/0365549 A1 (INTERMEC, INC.) 20 December 2018 (2018-12-20) entire text, all drawings | 1-5 |
| A | US 2004/0124916 A1 (IIT RESEARCH INSTITUTE) 01 July 2004 (2004-07-01) entire text, all drawings | 1-5 |
| A | EP 2330538 A1 (NXP B. V.) 30 November 2009 (2009-11-30) entire text, all drawings | 1-5 |

☐ Further documents are listed in the continuation of Box C.     ☑ See patent family annex.

| | |
|---|---|
| *     Special categories of cited documents: | "T"   later document published after the international filing date or priority date and not in conflict with the application but cited to understand the principle or theory underlying the invention |
| "A"   document defining the general state of the art which is not considered to be of particular relevance | |
| "E"   earlier application or patent but published on or after the international filing date | "X"   document of particular relevance; the claimed invention cannot be considered novel or cannot be considered to involve an inventive step when the document is taken alone |
| "L"   document which may throw doubts on priority claim(s) or which is cited to establish the publication date of another citation or other special reason (as specified) | "Y"   document of particular relevance; the claimed invention cannot be considered to involve an inventive step when the document is combined with one or more other such documents, such combination being obvious to a person skilled in the art |
| "O"   document referring to an oral disclosure, use, exhibition or other means | |
| "P"   document published prior to the international filing date but later than the priority date claimed | "&"   document member of the same patent family |

| Date of the actual completion of the international search | Date of mailing of the international search report |
|---|---|
| **12 November 2021** | **22 November 2021** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

## INTERNATIONAL SEARCH REPORT
### Information on patent family members

International application No.

**PCT/JP2021/030801**

| Patent document cited in search report | | | Publication date (day/month/year) | Patent family member(s) | | | Publication date (day/month/year) |
|---|---|---|---|---|---|---|---|
| JP | 2009-232372 | A | 08 October 2009 | US | 2009/0243804 | A1 | |
| | | | | entire text, all drawings | | | |
| | | | | EP | 2105861 | A1 | |
| | | | | CN | 101546370 | A | |
| US | 2018/0365549 | A1 | 20 December 2018 | EP | 3416088 | A1 | |
| | | | | entire text, all drawings | | | |
| | | | | CN | 109086852 | A | |
| US | 2004/0124916 | A1 | 01 July 2004 | WO | 2004/062097 | A1 | |
| | | | | entire text, all drawings | | | |
| EP | 2330538 | A1 | 30 November 2009 | (Family: none) | | | |

Form PCT/ISA/210 (patent family annex) (January 2015)

**EP 4 224 725 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005323223 A